# EUROPEAN PATENT APPLICATION

(11) **EP 3 093 329 A1**
(43) Date of publication of application: **16.11.2016**
(21) Application number: 16159045.0
(22) Date of filing: 07.03.2016
(51) Int. Cl.: C09K 21/12, C08L 63/04, C08K 5/00, C08K 5/5399, B32B 15/092, C08G 79/025

(54) **FLAME RETARDANT COMPOUNDS, HARDENERS AND POLYPHENOL-BASED EPOXY RESINS**

(30) Priority: 12.05.2015 CN 201510240719; 28.12.2015 CN 201511019248
(71) Applicant: Guangdong Guangshan New Materials Co., Ltd., Guangdong 523000 (CN)
(72) Inventor: PAN, Qingchong, 523000 GUANGDONG (CN)
(74) Representative: Weber, Jean-François

(57) **Abstract**

The present invention discloses flame retardant compounds, hardeners and polyphenol-based epoxy resins. In the molecular structure, such flame retardant compounds contain phenolic hydroxyl groups, and groups M of nitrogen phosphorus skeleton consisting of unsaturated phosphorous and nitrogen atoms, wherein M contains at least 50 wt% of cyclotriphosphazene groups M₁, at most 48 wt% of M₂, which is a cyclic ring consisting of four or more phosphazene groups, and at most 48 wt% of non-cyclic polyphosphazene groups M₃. Therefore, such flame retardant compounds have better flame retardancy, and the cured products thereof have better heat resistance, water resistance, cohesiveness, mechanical property and electrical property. Additionally, such compounds can improve flame retardancy, economy and envionmental friendly protection when applied in composite metal laminates and circuit boards.

## Description

### Technical Field

The present invention relates to the technical field of flame retardant substances, especially to flame retardant compounds, hardeners and polyphenol-based epoxy resins.

### Background Art

As for electronic products represented by cell phones, computers, video cameras, and video game consoles, household and office appliances represented by air conditioners, refrigerators, television sets and audio products, and various products used in other fields, most of the products are required to have different degrees of flame retardant property for safety's sake.

In order to make the products reach the required flame retardant performance or grade, inorganic flame retardant substances such as metal hydroxides containing crystal water, *e.g*. aluminium hydroxide, magnesium hydroxide, and organic chemical substances having a higher bromine content or a higher halogen content, *e.g*. bromide bisphenol A, bromide bisphenol A epoxy resin, are usually added into the material system in conventional technologies. For improving the flame retardancy of these organic chemical substances containing halogens, environmentally-unfriendly inorganic chemical flame retardant substances, such as antimonous oxide, are often added into the system.

When the flame retardant substances containing halogen combust, non-degradable or hard-to-decompose toxic substances, such as organic halogen chemical substances, *e.g*. dioxin, will be produced to pollute the environment and affect the health of humans and animals.

For the purpose of environmental protection, halogen-free compounds containing phosphorous and nitrogen are used as flame retardant to replace halogen-containing compounds. Especially in electronic, electric and electric appliance industries, monofunctional (there is only one active reactive group in one molecule) 9,10-dihydro-9-oxo-10-phosphaphenanthrene-10-oxide (abbreviated as DOPO) is used as flame retardant ingredient, and what's more, derivative compounds of DOPO are used. In addition, aluminium hydrate and magnesium hydrate are added or not to achieve flame retardant effect.

In the electronic field, the reaction products (abbreviated as DOPO epoxy resin) of DOPO and high-cost, multifunctional epoxy resin, such as linear phenolic epoxy resin, o-methyl phenolic epoxy resin and bisphenol A phenolic epoxy resin are wisely applied as the epoxy resin material for copper-clad plate use.

The copper-clad laminates produced by DOPO epoxy resin have better flame retardancy. However, they have many defects in cohesiveness, heat-resistance and processability, and thus cannot meet the demand of high multilayer, high reliability, high cohesiveness and better processability for manufacturing modem communications. In addition, due to high cost, they are disadvantageous to spread to the civilian goods field of low-cost consumer electronics, such as cell phones.

In the electronic field, DOPO and etherates, such as bisphenol A, bisphenol F, phenolic resin, phenol and o-cresol, react to produce phenol-containing compounds containing DOPO skeleton (collectively called phosphorous-containing phenolic resin) as the epoxy resin hardener or flame retardant additive, and as the flame retardant of the epoxy resin materials for copper-clad laminate use.

The copper-clad laminates produced by using phosphorous-containing phenolic aldehyde as a part of or all of the flame retardant ingredients can achieve flame retardancy. However, there are many defects in acid-base resistance properties, chemical resistance, cohesiveness, heat resistance, processability and so on, so that they cannot meet the demand of high multilayer, high reliability, high cohesiveness and better processability for manufacturing modem communications. In addition, due to high cost, they are disadvantageous to spread to the civilian goods field of low-cost consumer electronics, such as cell phones.

With further improvement of the electronic industry towards short, small, thin, high multilayer, and high reliable demand, with the popularization of civilian consumer electronics, and under the pressure of more and more serious environmental pollution, there is an urgent market demand for cheap flame retardant substances having better flame retardancy, heat resistance and better mechanical performance.

### Contents of the Invention

In view of that, on one hand, the present invention provides a flame retardant compound having better flame retardancy, heat resistance and better mechanical performance.

In order to achieve the above purpose, the present invention employs the following technical solution:

The present invention relates to a flame retardant compound, characterized in that the molecular structure thereof contains phenolic hydroxyl groups, and groups M of nitrogen phosphorus skeleton consisting of unsaturated phosphorous and nitrogen atoms, wherein M contains at least 50 wt% of cyclotriphosphazene groups M₁, at most 48 wt% of M₂, which is a cyclic ring consisting of four or more phosphazene groups, and at most 48 wt% of non-cyclic polyphosphazene groups M₃.

In the present invention, the sum of the mass percentages of M₁, M₂ and M₃ is 100%.

In the present invention, the flame retardant compound contains phenolic hydroxyl groups, which makes the compound be used for curing epoxy resin. The flame retardant compound can be a flame retardant and a curing agent of epoxy resin at the same time, giving the epoxy resin composition excellent flame retardancy, heat resistance and mechanical property.

In the present invention, the content of M₁ as a main component is at least 50wt%, i.e. 50-100wt%. When the content is 100wt%, there is no M₂ and M₃. The typical but non-limited content of M₁ in the present invention can be 50wt%, 51wt%, 55wt%, 58wt%, 60wt%, 65wt%, 70wt%, 74wt%, 75wt%, 80wt%, 85wt%, 90wt%, 92wt%, 95wt%, 98wt% or 100wt%.

In the present invention, the content of M₂ is at most 48wt%, i.e. 0-48wt%. When the content is 0wt%, it means that there is no M₂. The typical but non-limited content of M₂ in the present invention can be 0wt%, 2wt%, 5wt%, 8wt%, 11wt%, 14wt%, 17wt%, 20wt%, 23wt%, 26wt%, 29wt%, 32wt%, 35wt%, 38wt%, 42wt%, 45wt% or 48wt%.

In the present invention, the content of M₃ is at most 48wt%, i.e. 0-48wt%. When the content is 0wt%, it means that there is no M₃. The typical but non-limited content of M₃ in the present invention can be 0wt%, 2wt%, 5wt%, 8wt%, 11wt%, 14wt%, 17wt%, 20wt%, 23wt%, 26wt%, 29wt%, 32wt%, 35wt%, 38wt%, 42wt%, 45wt% or 48wt%.

In the present invention, if the content of M₁ is less than 50wt%, or the content of M₂ is more than 48wt%, the reaction product of the compound and epoxy resin will have decreased heat resistance, humidity resistance and mechanical property in use. If the content of M₃ is more than 48wt%, the reaction product of the compound and epoxy resin may result in inconvenient use due to large viscosity in use, and result in adverse consequence such as decrease properties due to large molecular weight.

Preferably, in the present invention, the flame retardant compound has a molecular structure as shown in Formula (I):

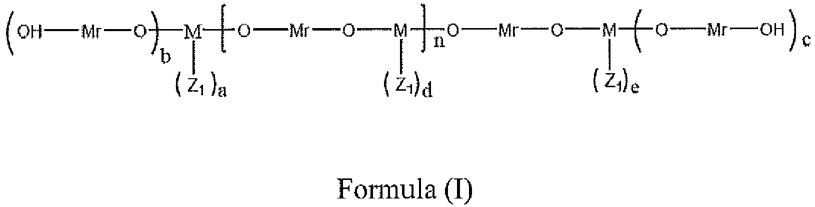

In Formula (I), M represents groups of nitrogen phosphorus skeleton consisting of unsaturated phosphorous and nitrogen atoms, i.e. phosphazene groups. Especially, M contains at least 50 wt% of cyclotriphosphazene groups M₁, at most 48 wt% of M₂, which is a cyclic ring consisting of four or more phosphazene groups, and at most 48 wt% of non-cyclic polyphosphazene groups M₃.

Mr represents substituted or unsubstituted aryl.

Z₁ is an inert nucleophilic group provided by nucleophile.

a, b, c, d and e are independently integers greater than or equal to zero, e.g. 1, 2, 3, 4, 5, 6, 7 or 8, preferably, satisfying a+b+1=2x, e+c+1=2x, d=2x-1.

n is an integer greater than or equal to zero, e.g. 1, 2, 3, 4, 5, 6, 7, 8 and 9.

In the present invention, preferably, M₁, M₂ and M₃ have the following structures respectively.

The structure of M₁ is

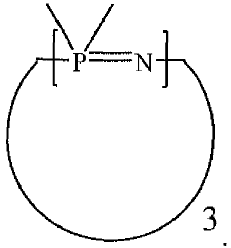

The structure of M₂ is 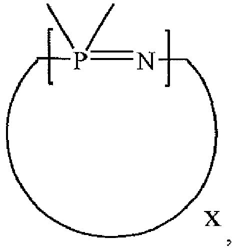 wherein, x is greater than or equal to 4.

The structure of M₃ is 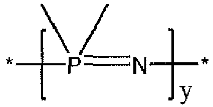 wherein, y is greater than or equal to 3.

It should be noted that the structure 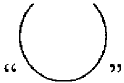 of the structural formulas of M₁ and M₃ is only a representation of cyclic structure. In the structure 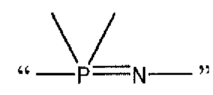 of the structural formulas of M₁, M₂ and M₃, the bonds connected to the P atom only represent that the substitutions of substituents take place on the P atom, and should not be construed as methyl.

As to the flame retardant compound of the present invention, it should be understood that the groups attached to M is attached to phosphorous atoms of M, i.e. to pendent groups of phosphorous atoms in the structures of M₁, M₂ and M₃. Further, the two single bonds presented on the P atoms in the structures of M₁, M₂ and M₃ cannot be understood as two methyl groups, and they only represent that M₁, M₂ and M₃ attach pendent groups through P atoms. M can attach phosphorous atoms in the same position or different positions.

The term "substituted" in the present invention means that any one or more hydrogen atoms on particular atoms are substituted by substituents of particular groups, on condition that the particular atoms do not exceed normal valence state, and the substituted results are to produce stable compounds. When the substituent is oxo group or ketone group (i.e. =O) the two hydrogen atoms on atoms are substituted. Ketone substituents do not exist on aromatic rings. "Stable compound" means compounds which can be separated to effective purity from reaction mixture and prepared to effective compounds.

In the present invention, Mr represents substituted or unsubstituted aryl.

Aryl means substituents derived from aromatic rings, including "conjugated" or polycyclic system. The examples are phenyl, benzyl, 1,2,3,4-tetrahydronaphthyl, 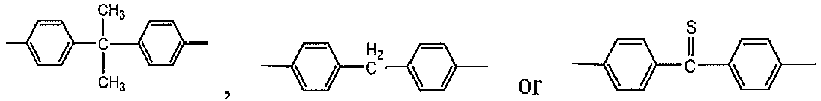 etc. The examples of phenyl are biphenyl, terphenyl, phenylmethyl, phenylethyl, and phenylpropyl, etc.

In the present invention, HO-Mr-O- and -O-Mr-O- are obtained by nucleophilic substitution reaction of aryl diphenols HO-Mr-OH and halogen atoms in halogenated phosphazene.

In the present invention, Z₁ is an inert nucleophilic group provided by nucleophile.

In the present invention, nucleophile means those which can conduct nucleophilic substitution reaction with halogenated phosphazene. During the nucleophilic substitution reaction, nucleophile removes leaving groups, nucleophilic groups attack halogen atoms in halogenated phosphazene, and nucleophilic groups are attached to M. For example, when employing methanol as a nucleophile to react with halogenated phosphazene, methanol removes H⁺, methoxyl substitutes halogen atoms in halogenated phosphazene and is attached to -P in phosphazene, Z₁ is CH₃O-.

In the present invention, Z₁ is an inert nucleophilic group. "Nucleophilic group" means a functional group without active group, which is difficult to react under common conditions for organic synthesis at an actual speed. It is a remaining functional group after the nucleophilic substitution reaction of nucleophile and chlorinated phosphazene compound, which cannot conduct general reaction.

In the present invention, the nucleophilic groups Z₁ is anyone selected from the group consisting of -OR₁, 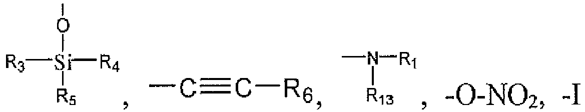 or 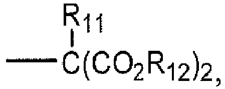 or a combination of at least two.

R₁ and R₁₃ are independently anyone selected from the group consisting of substituted or unsubstituted straight-chain or branched alkyl, substituted or unsubstituted cycloalkyl, substituted or unsubstituted aralkyl, substituted or unsubstituted alkoxy, substituted or unsubstituted cyclic alkoxy, substituted or unsubstituted aralkyloxy, substituted or unsubstituted alkyl aryloxy, substituted or unsubstituted carbonate, substituted or unsubstituted sulfonate, substituted or unsubstituted phosphonate, substituted or unsubstituted aryl or substituted or unsubstituted heteroaryl. R₃, R₄ and R₅ are independently anyone selected from the group consisting of substituted or unsubstituted straight-chain or branched alkyl, substituted or unsubstituted cycloalkyl, substituted or unsubstituted aralkyl, substituted or unsubstituted alkoxy, substituted or unsubstituted cyclic alkoxy, substituted or unsubstituted aralkyloxy, substituted or unsubstituted alkyl aryloxy, substituted or unsubstituted aryl or substituted or unsubstituted heteroaryl. R₆ is anyone selected from the group consisting of substituted or unsubstituted straight-chain or branched alkyl, substituted or unsubstituted cycloalkyl, substituted or unsubstituted aralkyl, substituted or unsubstituted alkoxy, substituted or unsubstituted cyclic alkoxy, substituted or unsubstituted aralkyloxy, substituted or unsubstituted alkyl aryloxy, substituted or unsubstituted aryl or substituted or unsubstituted heteroaryl. R₁₁ and R₁₂ are independently anyone selected from the group consisting of substituted or unsubstituted straight-chain or branched alkyl, substituted or unsubstituted cycloalkyl, substituted or unsubstituted aralkyl, substituted or unsubstituted alkoxy, substituted or unsubstituted cyclic alkoxy, substituted or unsubstituted aralkyloxy, substituted or unsubstituted alkyl aryloxy, substituted or unsubstituted aryl or substituted or unsubstituted heteroaryl.

In the previous text, the substituted or unsubstituted straight-chain or branched alkyl is preferably substituted or unsubstituted C1-C12 (for example, C1, C2, C3, C4, C5, C6, C7, C8, C9, C10 or C11) straight-chain or branched alkyl, preferably C1-C8 straight-chain or branched alkyl. When the number of carbon atom is 1, it is methyl; when the number of carbon atom is 2, it is ethyl.

The substituted or unsubstituted cycloalkyl is preferably C3-C12 (for example, C4, C5, C6, C7, C8, C9, C10 or C11) substituted or unsubstituted cycloalkyl.

The substituted or unsubstituted aryl is preferably phenyl, benzyl, 1,2,3,4-tetrahydronaphthyl, 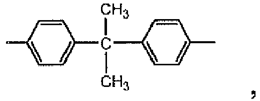 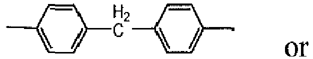 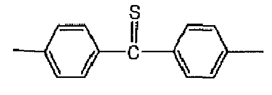 etc. The examples of phenyl are biphenyl, terphenyl, phenylmethyl, phenylethyl, and phenylpropyl, etc.

The unsubstituted aryl or substituted or unsubstituted heteroaryl is five-membered or six-membered heteroaryl.

The substituted or unsubstituted alkoxy is C1-C12 (for example, C1, C2, C3, C4, C5, C6, C7, C8, C9, C10 or C11) alkoxy.

The substituted or unsubstituted aralkyl is C7-C12 (for example, C8, C9, C10 or C11) aralkyl.

The substituted or unsubstituted cyclic alkoxy is C3-C8 (for example, C4, C5, C6, C7 or C8) cyclic alkoxy.

The substituted or unsubstituted aralkyloxy is C7-C12 (for example, C8, C9, C10 or C11) aralkyloxy.

The substituted or unsubstituted alkyl aryloxy is C7-C12 (for example, C8, C9, C10 or C11) alkyl aryloxy

Preferably, Z₁ is independently substituted or unsubstituted alkoxy or aryloxy.

The examples of alkoxy include, but not limited to, methoxy, ethoxy, isopropoxy, propoxy, butoxy and pentoxy. The alkoxy group can be substituted by the following substituent: alkenyl, alkynyl, halogen, hydroxyl, alkylcarbonyloxy, arylcarbonyloxy, alkoxycarbonyloxy, aryloxycarbonyloxy, carboxylate, alkylcarbonyl, arylcarbonyl, alkoxycarbonyl, aminocarbonyl, alkylaminocarbonyl, dialkylaminocarbonyl, alkoxy, phosphate, phosphonato, phosphinato, amino (including alkylamino, dialkylamino, arylamino, diarylamino, and alkylarylamino), acylamino (including alkylcarbonylamino, arylcarbonylamino, carbamoyl and ureido), amidino, imino, mercapto, alkylsulfinyl, sulfonate, sulfamoyl, sulfonamido, nitromethyl, trifluoromethyl, cyano, azido, heterocyclyl, alkylaryl or aromatic or heteroaromatic group. The examples of the alkoxy group substituted by halogen include, but not limited to, fluoromethoxy group, difluoromethoxy group, trifluoromethoxy group, chloromethoxy group, dichloromethoxy group, trichloromethoxy group.

The examples of aryloxy are phenoxy, benzyloxy, naphthyloxy or biphenyloxy. The aryloxy can be substituted by alkyl.

In the present invention, R₃, R₄ and R₅ in 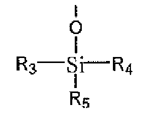 are independently substituted or unsubstituted straight-chain or branched alkyl, substituted or unsubstituted cycloalkyl, substituted or unsubstituted aralkyl, substituted or unsubstituted alkoxy, substituted or unsubstituted cyclic alkoxy, substituted or unsubstituted aralkyloxy, substituted or unsubstituted alkyl aryloxy, substituted or unsubstituted aryl or substituted or unsubstituted heteroaryl.

At the other hand, the present invention provides a method for preparing a flame retardant compound. The flame retardant prepared by the method has good flame retardant, heat resistance and good mechanical property.

The flame retardant compound above can be prepared by the method well known in the field. For example, by using metal chlorides, such as zinc chloride, magnesium chloride, aluminum chloride, boron trifluoride and complexes thereof as the catalyst, phosphorus cyanogen chloride reacts with nucleophile such as bisphenol A or metal salts thereof etc. under alkaline conditions with or without solvents. These catalysts may be used alone or in combination, which is not specially defined in the present invention. Said "phosphorus cyanogen chloride" refers to the compound formed by connecting M group in Formula (I) with Cl. Phosphorus cyanogen chloride can be synthesized by using well-known solvents and catalysts and using well-known reaction route, or directly made by purifying via physical methods or not purifying after chlorinated phosphorus cyanide compound is synthesized by using phosphorus pentachloride and ammonia chloride via the well-known methods, *i.e.* PCl₅⁺ NH4Cl → l/n(NPC12)n+ 4 HCl. The products are trimer (PNCl₂)₃ (*i.e.* hexachlorocyclotriphosphazene) and tetramer (PNCl₂)₄, and non-cyclic phosphazene compounds and the products are then slowly sublimated in vacuum at 60 °C to obtain pure hexachlorocyclotriphosphazene.

In the above method, nucleophile necessarily comprises polyphenolic compounds containing at least two phenolic hydroxyl groups (i.e. HO-Mr-OH, Mr defined as above). Exemplary polyphenolic compounds are difunctional phenolic compounds, such as hydroquinone, resorcinol, naphthalene diol, mixed hydroquinone, 1,4-naphthol, bisphenol A, bisphenol S or bisphenol F.

In the present invention, aryl derives from aromatic compounds containing at least two phenolic hydroxyl groups (obtained by substituting hydrogen atom on aryl with -OH).

In addition to the nucleophile polyphenolic compounds, other nucleophile can be used. For example, the flame retardant compound of Formula (I) can be obtained by substituting a part of chlorine of chlorinated phosphazene with nucleophile containing Z₁, and then substituting with the above polyphenolic compounds.

In the present invention, the phosphazene compounds contain no chlorine.

On the other side, the present invention provides a hardener of epoxy resin, and epoxy resin cured products obtained by using such hardener have better flame retardancy, heat resistance and better mechanical performance. The specific solution is as following:

A part or all of the components of the hardener of epoxy resin are the flame retardant compound above.

The above flame retardant compound contains -OH, making the compound be used as a hardener of epoxy resin.

For the hardener of the present invention, there is no special definition of the amount of the flame retardant compound. For example, the hardener can only comprise the above flame retardant compound, or further comprise other hardeners. For example, when the employed nucleophile is hydroquinone, phenol phosphorus and nitrogen compounds is obtained. Under such circumstance, the above flame retardant compound is in an amount of higher than 30%, especially from 55% to 100% of the total mass of all the hardeners, excluding 100%, based on the equivalent amount of the reactive group reacting with epoxy resin. It is understandable that "all the hardeners" means the above flame retardant compound and other epoxy resin hardeners. The term "based on the equivalent weight of the reactive group reacting with epoxy resin" refers to that the relative amounts of phenol P-N compounds and the other hardener are both based on the equivalent weight of the reactive groups, which react with epoxy resin, contained therein.

When the hardener further comprises other hardeners in addition to the above flame retardant compound, other hardeners may be common hardeners of epoxy resin in the art. Specific examples of the hardener are any one selected from the group consisting of polyphenolic compounds containing no phosphorous or nitrogen, polyphenolic compounds containing nitrogen, polyphenolic compounds containing phosphorous, polyphenolic compounds containing nitrogen and phosphorous, amino compounds, benzoxazine resins, acid anhydride, polybasic acids, boron trifluoride and complexes thereof, or a combination of at least two. Said amino compounds are aliphatic amines or aromatic amines selected from the group consisting of dicyandiamide, diethyltriamine, diaminodiphenylmethane, diaminodiphenylsulfone. Said polyphenolic compounds are one selected from the group consisting of bisphenol A, bisphenol F, bisphenol S, linear phenolic resin, o-methyl phenolic resin and bisphenol A phenolic resin, or a combination of at least two.

On the other side, the present invention further provides an epoxy resin composition having better flame retardancy, heat resistance and better mechanical performance.

The epoxy resin composition comprises epoxy resin and the hardener of epoxy resin above.

The present invention does not specially define the specific types of epoxy resin in the epoxy resin composition, as long as there are compounds containing epoxy groups, *i.e.* epoxy resin. The common epoxy resins in the art may be used, *e.g.* difunctional epoxy resins represented by liquid bisphenol A epoxy resin, liquid bisphenol F epoxy resin, solid bisphenol A epoxy resin, solid bisphenol F epoxy resin, bisphenol S epoxy resin, and biphenyl epoxy resin, multifunctional epoxy resins represented by solid, liquid or semi-solid linear phenolic epoxy resin, o-methyl phenolic epoxy resin, bisphenol A phenolic epoxy resin, and cyclo-isoprene epoxy resin. Those skilled in the art can readily understand that epoxy resins having a lower viscosity, such as alicyclic epoxy resin, chain aliphatic epoxy resin or ester epoxy resin, can also be used when necessary, wherein these epoxy resins can be used alone or in combination, which is not specifically defined in the present invention. The present application does not specifically define the amounts of these epoxy resins, as long as the target materials can be obtained on the premise of ensuring the safety, environmental protection and performance as required.

In the epoxy resin composition, the usage amounts of the epoxy resin and the hardener should be sufficient to cure the epoxy resin completely.

According to actual requirements, the epoxy resin composition may further comprise curing accelerator, solvent, reinforcing materials, fillers, auxiliaries, flame retardant epoxy resin, mono-aromatic ring phenolic P-N epoxy resin, phenolic resin, benzoxazine resin and maleimide resins, etc.
The curing accelerator is used to accelerate the curing. The curing accelerator used in the present invention is not specifically defined, and the common curing accelerators for epoxy resin may be used, such as common catalysts of curing reaction, e.g. imidazoles, triphenylphosphine and derivatives thereof, tertiary amines, quaternary amines, boron trifluoride and derivatives thereof. These accelerators may be used alone or in combination, and the amount thereof is based on obtaining the target material as required in a safe and environmental protection way. The present invention does not specifically define the amount thereof, and it is generally from 0.001% to 2.5%, more preferably from 0.03% to 1.2% as compared with the epoxy resin in the curing system.

Solvents are primarily used for dispersing the hardeners and epoxy resins in the epoxy resin composition, and can be used to obtain high quality prepregs and bonding sheets by using epoxy compositions. The present invention does not specifically define the type or amount of solvent. Organic solvent, such as acetone, butanone, DMF, DMAC, ethanol, methanol, cyclohexanone, 1,4-dioxane, petroleum solvent, toluene, dimethylbenzene, dichloromethane, dimethylcarbonate and the like, may be used, as long as the target materials can be obtained on the premise of ensuring the safety, environmental protection and performance as required.

Preferably, organic solvents, such as butanone, having better dissolubility, weak toxicity, appropriate boiling point, are used. If the epoxy resin components comprise crystalline substances which are difficult to dissolve, e.g. dicyanodiamide, a part of or all nitrogen-containing organic solvents can be used, *e.g.* DMF, DMAC and the like. It is understandable the evaporation rate of solvents can be improved by heating during the curing process.

Reinforcing materials are based on improving the mechanical properties of the final cured products, and the examples thereof are any one selected from the group consisting of glass fibers, carbon fibers and polyester fibers, or a combination of at least two.

Fillers are added to add some functions, properties or reduce the cost. Inorganic fillers, such as silicon dioxide, diatomite, kaoline, calcium carbonate, mica, titanium dioxide, magnesium hydroxide, aluminium hydroxide, and organic fillers, such as polyphenylene sulfide powder and polyphenylene ether powder, may be added alone or in combination to the curing system. The amount thereof is better to be no more than 500 times of the epoxy resin components.

Auxiliaries may be added to the system according to actual requirements. Auxiliaries may be general or special auxiliaries, *e.g.* defoaming agents, coupling agents, flexibilizers, flatting agents, releasing agents and the like. The present invention does not specifically define the types or amounts of auxiliaries, which are based on obtaining the target material as required in a safe and environmental protection way.

In order to improve the flame retardancy of the epoxy resin composition, mono-aromatic ring polyphenolic P-N epoxy resins and other flame retardant epoxy resins may be added to the epoxy resin compositions. The other flame retardant epoxy resins are epoxy resins having a preferred halogen content, but not being defined to no higher than 0.2wt%. Specific examples of the other flame retardant epoxy resin are one or at least two selected from the group consisting of DOPO epoxy resin, phosphorous-containing epoxy resin, nitrogen-containing epoxy resin, nitrogen-phosphorous-containing epoxy resin, phosphorous-containing phenolic epoxy resin, nitrogen-phosphorous-containing phenolic epoxy resin, silicon-containing epoxy resin and sulfur-containing epoxy resin. Polyphenolic P-N epoxy resin is obtained by condensing the flame retardant compounds and epoxy resin, and the specific process of the condensation will be described hereinafter.

On the other side, the present invention further provides a polyphenolic P-N epoxy resin having better flame retardancy, heat resistance and better mechanical performance.

The polyphenolic P-N epoxy resin is an epoxy resin product obtained by the polycondensation reaction of non-halogen epoxy resin and the above flame retardant compounds under the condition of surplus of epoxy resin functional groups.

Said "surplus of epoxy resin functional groups" is based on the epoxy equivalent of the epoxy resin product of less than 3585 g/eq, more preferably less than 1520 g/eg.

In the polycondensation, the reaction temperature ranges between 40 °C and 250 °C, preferably between 60°C and 180°C. On the premise of ensuring the safety and environmental protection, the present invention does not make any definition on the basis of obtaining the target material. Such polycondensation can be carried out with catalysts or without catalysts. Generally, catalysts are needed to add into the reaction system. The present invention does not specially define the types and addition amounts of catalysts. Generally, common catalysts which can make epoxy resins react with phenolic substances, such as imidazoles, triphenylphosphine and derivatives thereof, tertiary amines, quaternary amines, can be used. These catalysts can be used alone, or in combination, in an amount of from 100 to 20000 ppm, preferably from 200 to 5000 ppm, relative to the reactive materials in the system. As to the reaction medium, it may comprise solvent or no solvent. The reaction solvent is not specially defined. For example, ketone solvents such as acetone, butanone, cyclohexanone, aromatic solvents such as benzene, toluene, dimethylbenzene, mixed dimethylbenzene, organic chlorine-containing solvents such as dichloromethane, trichloromethane, chlorobenzene, ether or ether-alcohol solvents such as ethyl ether, butyl ether, ethylene glycol monomethyl ether, petroleum solvent oil, alcohol solvents such as butanol, isobutanol and the like, can be used alone, or in combination. The amount thereof is determined according to actual situation, generally is the amount which makes the solid content of polyphenolic P-N epoxy resin from 5% to 100%, especially from 20% to 100%. The basic principle of the polycondensation is a well-known technology, and will not be repeated herein.

The present invention does not specifically define the non-halogen epoxy resin. Such "non-halogen epoxy resin" refers to epoxy resins containing no halogen atoms, or epoxy resin having a very low halogen content, for example, difunctional epoxy resins represented by liquid bisphenol A epoxy resin, liquid bisphenol F epoxy resin, solid bisphenol A epoxy resin, solid bisphenol F epoxy resin, bisphenol S epoxy resin, and biphenyl epoxy resin, multifunctional epoxy resins represented by solid, liquid or semi-solid linear phenolic epoxy resin, o-methyl phenolic epoxy resin, bisphenol A phenolic epoxy resin, and cyclo-isoprene epoxy resin. Those skilled in the art can readily understand that epoxy resins having a lower viscosity, such as alicyclic epoxy resin, chain aliphatic epoxy resin or ester epoxy resin, can also be used when necessary, wherein these epoxy resins can be used alone or in combination, which is not specifically defined in the present invention. As to the epoxy resins above, a part of or most of them may participate in the reaction, and other epoxy resins may be added after the reaction goes to a certain extent or after the complete reaction. Or all the necessary epoxy resins may be stage-added, or one-off added into the reaction. The present application does not specifically define the amounts of these epoxy resins, as long as the target materials can be obtained on the premise of ensuring the safety, environmental protection and performance as required.

On the other side, the present invention provides a flame retardant composition having better flame retardancy, heat resistance and better mechanical performance.

The flame retardant composition comprises the aforesaid polyphenolic P-N epoxy resin as stated above.

The flame retardant composition above may comprise only polyphenolic epoxy resin, or other flame retardant resins, such as DOPO epoxy resin, phosphorous-containing epoxy resin, nitrogen-containing epoxy resin, nitrogen-phosphorous-containing epoxy resin, phosphorous-containing phenolic epoxy resin, nitrogen-phosphorous-containing phenolic epoxy resin, silicon-containing epoxy resin and sulfur-containing epoxy resin. Hardeners, auxiliaries, curing accelerators and halogen-free flame retardant fillers may be added as required.

The present invention does not specifically define the hardener, and common substances as epoxy resin hardeners can be used as the hardeners of epoxy resins in the present invention. Specific examples thereof may be amino compounds, such as aliphatic or aromatic amines, *e.g*. dicyandiamide, diethyltriamine, diaminodiphenylmethane, diaminodiphenylsulfone, or two or more phenolic compounds or mixtures thereof, such as bisphenol A, bisphenol F, bisphenol S, linear phenolic resin, bisphenol A phenolic resin, benzoxazine resins, acid anhydride, polybasic acids, boron trifluoride and complexes thereof. These epoxy resin hardeners may be used alone, or in combination, and the equivalence ratio between the amount thereof and that of epoxy resins is generally from 0.4 to 1.5 (eq).

In order to speed up the curing, curing accelerator may often be added. The present invention does not specifically define the curing accelerator, and the curing accelerators usually used for epoxy resins can be used, such as epoxy resin hardeners for curing reaction, e.g. imidazoles, triphenylphosphine and derivatives theroeof, tertiary amines, quaternary amines, boron trifluoride and derivatives ) thereof. These accelerators can be used alone, or in combination. The present application does not specifically define the amounts thereof, as long as the target materials can be obtained on the premise of ensuring the safety, environmental protection and performance as required. Generally, the amount thereof is suitable to be from 0.001wt% to 2.5wt%, preferably from 0.03wt% to 1.2wt%, relative to the epoxy resin ingredients in the curing system.

In order to increase some functions, properties or reduce the cost, inorganic fillers such as silicon dioxide, diatomite, kaoline, calcium carbonate, mica, titanium dioxide, magnesium hydroxide, aluminium hydroxide, can be added to the curing system. These inorganic fillers may be added alone or in combination, and the amount thereof is better to be no more than 500 phr (representing the parts per 100 grams) of the epoxy resin components.

As to the flame retardant compositions, some general or special substances, such as defoaming agents, coupling agents, flexibilizers, flatting agents and the like, may be added into the system. The present invention does not specifically define the types or addition amounts of the auxiliaries added, as long as the target materials can be obtained on the premise of ensuring the safety and environmental protection as required.

A prepreg is formed by impregnating or coating the aforesaid flame retardant composition onto a substrate. The substrate may be glass fiber substrate, polyester substrate, polyimide substrate, ceramic substrate or carbon fiber substrate. The specific technological conditions for impregnating or coating are not specifically defined. Said "prepreg" is also the "bonding sheet" well known by those skilled in the art.

A composite metal laminate comprises more than one prepreg above, being produced by successively coating a metal layer on the surface of the prepreg, overlapping and pressing. The metal layer is made of aluminium, copper, iron and alloys of any combinations thereof; Specific examples of the composite metal laminate include, but not limited to, CEM-1 copper-clad laminate, CEM-3 copper-clad laminate, FR-4 copper-clad laminate, FR-5 copper-clad laminate, CEM-1 aluminum-clad laminate, CEM-3 aluminum-clad laminate, FR-4 aluminum-clad laminate or FR-5 aluminum-clad laminate.

A circuit board is formed by processing circuit on the surface of the composite metal laminate above.

The raw materials of the flame retardant composition or epoxy resin composition are cured on the composite metal laminate to form coatings having better flame retardant performances, which may increase wide applications in the industries of machines, equipments, apparatus, instruments which need circuit boards, such as electronic industries, electric industries, communication and transportation, aerospace and aviation, toy industries and the like.

The term "group" refers to the remaining part after removing one or more hydrogen atoms or other atoms or radicals from the molecular structure of some compounds.

The present invention employs M groups of specific components to obtain flame retardant compounds, so as to make the flame retardant compounds have better flame retardancy. The cured products thereof have better heat resistance, water resistance, cohesiveness, mechanical and electrical performance, and are environmentally-friendly flame retardant substances having a great economy. The copper-clad laminate prepared from the flame retardant compound has a Tg of 156°C or more, a T-peeling strength of 2.1kg/mm² or more, a interlaminar peeling strength of 1.87 kg/mm² or more, a saturated water absorption of 0.25% or less, a thermal decomposition temperature of 403 °C or more, a bending strength of 12.6 kg/mm² or more, and the flame retardancy (UL-90) can reach V-0 grade.

### Embodiments

The technical solutions of the present inventions are further explained by combining with the following examples.

### Example 1

A phosphazene compound was prepared by the following method:
(1) 1 mol of hexachlorocyclotriphosphazene, 500 ml of acetone, 4 mol of sodium methoxide and 2 mol of hydroquinone were added to a 3-neck glass reactor having a volume of 2000 ml and having a stirring apparatus. While stirring, nitrogen was fed therein, and the reactor was heated to 40°C. 300 g of 20% sodium hydroxide solution was dripped within 60 min, and then held at 45°C, stirred and reacted for 15 hours;
(2) 1 mol of hexachlorocyclotriphosphazene, 500 ml of acetone, 4 mol of sodium methoxide and 1 mol of hydroquinone were added to the reactor sequentially. While stirring, nitrogen was fed therein, and the reactor was heated to 40°C. 300 g of 20% sodium hydroxide solution was dripped within 60 min, and then held at 45°C, stirred and reacted for 15 hours;
(3) 1 mol of hexachlorocyclotriphosphazene, 500 ml of acetone, 4 mol of sodium methoxide and 1 mol of hydroquinone were added to the reactor sequentially. While stirring, nitrogen was fed therein, and the reactor was heated to 40°C. 300 g of 20% sodium hydroxide solution was dripped within 60 min, and then held at 45°C, stirred and reacted for 15 hours;
(4) After reaction, water in the system was removed by physical method; the insoluble substance in the system was removed by filtration; the solvent in the system was distilled to obtain 1 mol of flame retardant compound of the following structure. The flame retardant compound was measured to have a phenolic equivalent of 615 g/eq, and such target compound was named flame retardant compound A.

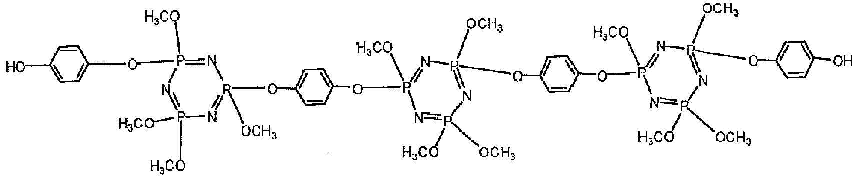

### Structure Characterization:

Infrared observations: phenolic hydroxyl group 3200-3350cm⁻¹; benzene ring 1500-1600cm⁻¹ 2900-3100 cm⁻¹;
1H-NMR (DMSO-d6, ppm): 6.54-6.58 (hydrogen of benzene ring); 3.38-3.40 (hydrogen of methoxyl);
Application Example 1:615 g (1eq) of flame retardant compound A of Example 1 and 105 g of linear phenolic resin having an epoxy equivalent of 105 g/eq (1eq) were used as hardener; 187 g of liquid bisphenol A epoxy resin having an epoxy equivalent of 187 g/eq and 120 g of linear phenolic epoxy resin having an epoxy equivalent of 120 g/eq were used as epoxy resins; 0.08 g of 2-methylimidazole and a suitable amount of butanone were added and homogeneously stirred to form a solution named Composition-1, wherein the equivalence ratio between the epoxy resins and the hardener was 1. Thereafter, the Composition-1 was used to prepare standard copper-clad laminate sample according to common procedures of making copper-clad laminates, which satisfied the standards such as national standard and UL and was named Copper-clad Laminate a. The performances of Copper-clad Laminate a were tested, and the results were shown in Table-1.

### Example 2

The differences of Example 2 from Example 1 lie in: there is an additional step (3') after step (3): 1 mol of hexachlorocyclotriphosphazene, 500 ml of acetone, 4 mol of sodium methoxide and 1 mol of hydroquinone were added to the reactor sequentially. While stirring, nitrogen was fed therein, and the reactor was heated to 40°C. 300 g of 20% sodium hydroxide solution was dripped within 60 min, and then held at 45°C, stirred and reacted for 15 hours;
And a flame retardant compound B of the following structure was obtained, having a phenolic equivalent of 800 g/eq.

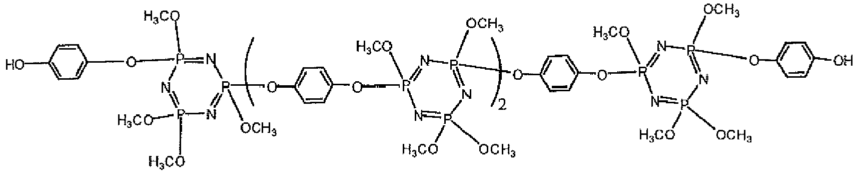

### Application Example 2:

The differences of Application Example 2 from Application Example 1 lie in: the flame retardant compound A was replaced with the flame retardant compound B based on the same equivalent, and the obtained Copper-clad Laminate was named Copper-clad Laminate b.

### Example 3

The differences of Example 3 from Example 1 lie in: the hydroquinone was replaced with bisphenol A based on the same mole, and a flame retardant compound of the following structure was obtained, having a phenolic equivalent of 793 g/eq, which was named flame retardant compound C.

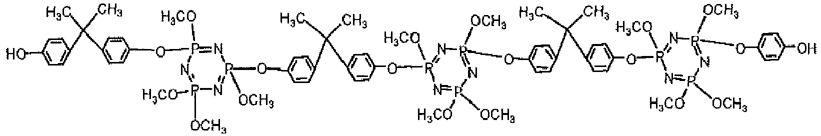

### Application Example 3:

The differences of Application Example 3 from Application Example 1 lie in: the flame retardant compound A was replaced with the flame retardant compound C based on the same equivalent, and the obtained Copper-clad Laminate was named Copper-clad Laminate c.

### Example 4

The differences of Example 4 from Example 2 lie in: the hydroquinone was replaced with bisphenol A based on the same mole, and a flame retardant compound of the following structure was obtained, having a phenolic equivalent of 1033 g/eq, which was named flame retardant compound D.

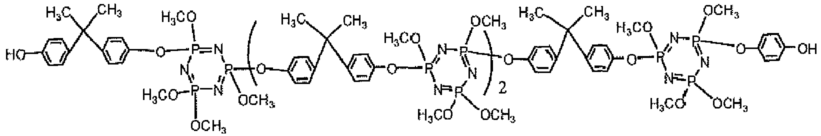

### Application Example 4:

The differences of Application Example 4 from Application Example 1 lie in: the flame retardant compound B was replaced with the flame retardant compound D based on the same equivalent, and the obtained Copper-clad Laminate was named Copper-clad Laminate d.

### Comparison Example 1

100.0g of DOPO-modified phosphorous-containing epoxy resin having an epoxy equivalent of 310 g/eq (produced by Guangdong Guangshan New Materials Co. Ltd, YEP-240 having a phosphorous content of 2.4% in the epoxy resin) was dissolved in a suitable amount of butanone. 3.2 g of dicyandiamide hardener was added, and then a suitable amount of DMF and 0.08 g of 2-methylimidazole were added to formulate a solution and to prepare standard copper-clad laminate sample according to common procedures of making copper-clad laminates, which satisfied the standards such as national standard and UL and was named Copper-clad Laminate h. The performances of Copper-clad Laminate h were tested, and the results were shown in Table-1.

### Comparison Example 2

100.0g of DOPO-modified phosphorous-containing epoxy resin having an epoxy equivalent of 308 g/eq (produced by Guangdong Guangshan New Materials Co. Ltd, YEP-340 having a phosphorous content of 3.3% in the epoxy resin) was dissolved in a suitable amount of butanone. 34.1 g of linear phenolic resin hardener having a phenolic equivalent of 105.g/eq and 0.08 g of 2-methylimidazole were added to formulate a solution and to prepare standard copper-clad laminate sample according to common procedures of making copper-clad laminates, which satisfied the standards such as national standard and UL and was named Copper-clad Laminate i. The performances of Copper-clad Laminate i were tested, and the results were shown in Table-1.

The testing results in the examples and comparison examples are shown in Table-1 below (since the specific testing methods are well known by those skilled in the art, they are not detailedly repeated hereinafter).

**Table-1 Performance comparison of various copper-clad laminate**

| Testing items | copper-clad laminate a | copper-clad laminate b | copper-clad laminate c | copper-clad laminate d | copper-clad laminate h | copper-clad laminate i |
|---|---|---|---|---|---|---|
| Tg(DSC) (°C) | 163 | 170 | 166 | 172 | 158 | 157 |
| T-peeling strength (kg/mm²) | 2.1 | 2.7 | 2.3 | 3.2 | 1.7 | 1.5 |
| Interlaminar peeling strength (kg/mm²) | 1.9 | 1.87 | 1.92 | 1.89 | 0.85 | 0.75 |
| Saturation water absorption (%) | 0.20 | 0.19 | 0.21 | 0.22 | 0.56 | 0.45 |
| thermal decomposition temperature (°C) | 403 | 415 | 421 | 403 | 385 | 392 |
| Bending strength (kg/mm²) | 12.8 | 13.0 | 13.2 | 13.0 | 10.3 | 10.8 |
| Inflammability (UL-90) | V-0 | V-0 | V-0 | V-0 | V-0 | V-0 |

The testing data in the table above show that, when used in epoxy resin curing system and other systems, the flame retardant compounds of the present invention and the derivatives thereof have better flame retardancy, and the cured products thereof have better heat resistance, water resistance, cohesiveness, mechanical and electrical performances. The flame retardant compounds of the present invention are new environmentally-friendly flame retardant substances having a low cost, a rich material source, better properties and being of energy saving and emission reduction.

The applicant declares that, the present invention describes the detailed technological equipment and process by the aforesaid examples, but the present invention is not limited by the aforesaid detailed technological equipment and process. That is to say, it does not mean that the present invention cannot be fulfilled unless relying on the aforesaid detailed technological equipment and process. Those skilled in the art shall know that, any amendments, equivalent changes to the product materials of the present invention, addition of auxiliary ingredients, and selection of any specific modes all fall within the protection scope and disclosure scope of the present invention.

## Claims

1. A flame retardant compound, **characterized in that** the molecular structure thereof contains phenolic hydroxyl groups, and groups M of nitrogen phosphorus skeleton consisting of unsaturated phosphorous and nitrogen atoms,
wherein M contains at least 50 wt% of cyclotriphosphazene groups M₁, at most 48 wt% of M₂, which is a cyclic ring consisting of four or more phosphazene groups, and at most 48 wt% of non-cyclic polyphosphazene groups M₃.

2. The flame retardant compound of claim 1, **characterized in that** the flame retardant compound has a molecular structure as shown in Formula (I): 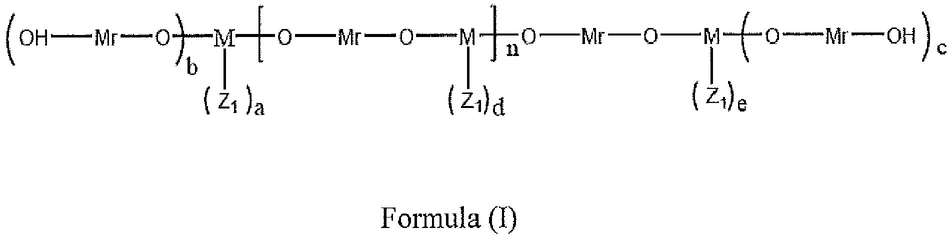
in Formula (I), M represents groups of nitrogen phosphorus skeleton consisting of unsaturated phosphorous and nitrogen atoms, i.e. phosphazene groups, having x phosphorous atoms, especially: M contains at least 50 wt% of cyclotriphosphazene groups M₁, at most 48 wt% of M₂, which is a cyclic ring consisting of four or more phosphazene groups, and at most 48 wt% of non-cyclic polyphosphazene groups M₃;
Mr represents substituted or unsubstituted aryl;
Z₁ is an inert nucleophilic group;
a, b, c, d and e are independently integers greater than or equal to zero, preferably, satisfying a+b+1=2x, e+c+1=2x, d=2x-1;
n is an integer greater than or equal to zero.

3. The flame retardant compound of claim 1 or 2, **characterized in that** the structure of M₁ is 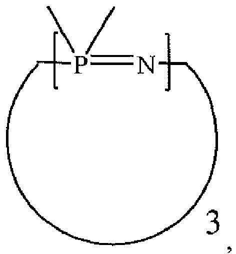 the structure of M₂ is 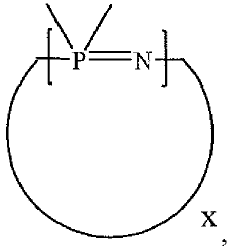 wherein, x is greater than or equal to 4,
the structure of M₃ is 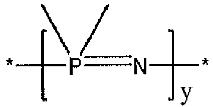 wherein, y is greater than or equal to 3,
preferably, the nucleophilic groups Z₁ is anyone selected from the group consisting of -OR₁, 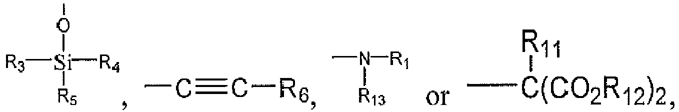 or a combination of at least two;
R₁ and R₁₃ are independently anyone selected from the group consisting of substituted or unsubstituted straight-chain or branched alkyl, substituted or unsubstituted cycloalkyl, substituted or unsubstituted aralkyl, substituted or unsubstituted alkoxy, substituted or unsubstituted cyclic alkoxy, substituted or unsubstituted aralkyloxy, substituted or unsubstituted alkyl aryloxy, substituted or unsubstituted carbonate, substituted or unsubstituted sulfonate, substituted or unsubstituted phosphonate, substituted or unsubstituted aryl or substituted or unsubstituted heteroaryl; R₃, R₄ and R₅ are independently anyone selected from the group consisting of substituted or unsubstituted straight-chain or branched alkyl, substituted or unsubstituted cycloalkyl, substituted or unsubstituted aralkyl, substituted or unsubstituted alkoxy, substituted or unsubstituted cyclic alkoxy, substituted or unsubstituted aralkyloxy, substituted or unsubstituted alkyl aryloxy, substituted or unsubstituted aryl or substituted or unsubstituted heteroaryl; R₆ is anyone selected from the group consisting of substituted or unsubstituted straight-chain or branched alkyl, substituted or unsubstituted cycloalkyl, substituted or unsubstituted aralkyl, substituted or unsubstituted alkoxy, substituted or unsubstituted cyclic alkoxy, substituted or unsubstituted aralkyloxy, substituted or unsubstituted alkyl aryloxy, substituted or unsubstituted aryl or substituted or unsubstituted heteroaryl; R₁₁ and R₁₂ are independently anyone selected from the group consisting of substituted or unsubstituted straight-chain or branched alkyl, substituted or unsubstituted cycloalkyl, substituted or unsubstituted aralkyl, substituted or unsubstituted alkoxy, substituted or unsubstituted cyclic alkoxy, substituted or unsubstituted aralkyloxy, substituted or unsubstituted alkyl aryloxy, substituted or unsubstituted aryl or substituted or unsubstituted heteroaryl.

4. A hardener of epoxy resin, **characterized in that** a part of or all components of the hardener are the flame retardant compound as claimed in anyone of claims 1-3;
preferably, the flame retardant compound is in an amount of higher than 30% of the total mass of all the hardeners, based on the equivalent amount of reactive groups reacting with epoxy resin, preferably from 55% to 100%;
preferably, the hardener further contains other hardener which is one selected from the group consisting of polyphenolic compounds containing no phosphorous or nitrogen, polyphenolic compounds containing nitrogen, polyphenolic compounds containing phosphorous, polyphenolic compounds containing nitrogen and phosphorous, amino compounds, benzoxazine resins, acid anhydride, polybasic acids, boron trifluoride and complexes thereof, or a combination of at least two;
preferably, the amino compounds are anyone selected from the group consisting of dicyandiamide, diethyltriamine, diaminodiphenylmethane, or diaminodiphenylsulfone, or a combination of at least two;
preferably, the polyphenolic compounds are one selected from the group consisting of bisphenol A, bisphenol F, bisphenol S, linear phenolic resin, o-methyl phenolic resin or bisphenol A phenolic resin, or a combination of at least two.

5. An epoxy resin composition, **characterized in** containing epoxy resin and the hardener as claimed in claim 4;
preferably, the epoxy resin is a bifunctional or multifunctional epoxy resin;
preferably, the bifunctional epoxy resin is one selected from the group consisting of liquid bisphenol A epoxy resin, liquid bisphenol F epoxy resin, solid bisphenol A epoxy resin, solid bisphenol F epoxy resin and bisphenol S epoxy resin or biphenyl-type epoxy resin, or a combination of at least two;
preferably, the multifunctional epoxy resin is one selected from the group consisting of phenolic epoxy resin, o-methyl phenolic epoxy resin, bisphenol A phenolic epoxy resin or cyclo-isoprene epoxy resin, or a combination of at least two;
preferably, further containing polyphenolic P-N-epoxy resin produced by the condensation of the flame retardant compound as claimed in anyone of claims 1-3 and epoxy resin, and other flame retardant epoxy resin;
preferably, the other flame retardant epoxy resin has a halogen content of no higher than 0.2%;
preferably, the other flame retardant epoxy resin is one selected from the group consisting of DOPO epoxy resin, phosphorous-containing epoxy resin, nitrogen-containing epoxy resin, nitrogen-phosphorous-containing epoxy resin, phosphorous-containing phenolic epoxy resin, nitrogen-phosphorous-containing phenolic epoxy resin, silicon-containing epoxy resin and sulfur-containing epoxy resin, or a combination of at least two;
preferably, the epoxy resin composition further contains a curing accelerator, preferably the curing accelerator is one or at least two selected from the group consisting of imidazoles, triphenylphosphine and derivatives theroeof, tertiary amines, quaternary amines, boron trifluoride and derivatives thereof;
preferably, the curing accelerator is in an amount of from 0.001% to 2.5%, more preferably from 0.03% to 1.2% of the total mass of epoxy resin;
preferably, the epoxy resin composition further contains reinforcing materials and fillers;
preferably, the reinforcing materials are one selected from the group consisting of glass fibers, carbon fibers and polyester fibers, or a combination of at least two;
preferably, the fillers are one selected from the group consisting of silicon dioxide, diatomite, kaoline, calcium carbonate, mica, titanium dioxide, magnesium hydroxide, and aluminium hydroxide, or a combination of at least two;
preferably, the fillers are in an amount of no more than 500 times of the total mass of epoxy resin;
preferably, the epoxy resin composition further contains auxiliaries which are one or at least two selected from the group consisting of defoaming agents, coupling agents, flexibilizers and flatting agents.

6. A polyphenolic P-N epoxy resin, **characterized in that** it is an epoxy resin product obtained by the reaction of non-halogen epoxy resin and the flame retardant compound as claimed in anyone of claims 1-3 under the condition of surplus of epoxy resin functional groups;
preferably, the epoxy resin product has an epoxy equivalent of less than 3585 g/eq, more preferably less than 1520 g/eq;
preferably, the reaction is carried out with or without curing accelerators; preferably, the curing accelerators are one or more selected from the group consisting of imidazoles, triphenylphosphine and derivatives theroeof, tertiary amines and quaternary amines;
preferably, the curing accelerator s are in an amount of from 0.01% to 2.5%, more preferably from 0.02% to 0.5% of mono-aromatic ring phenolic phosphorus and nitrogen compounds;
preferably, the reaction temperature is from 40°C to 250°C, more preferably from 60°C to 180°C;
preferably, the reaction is carried out with or without solvents, wherein the solvents are one selected from the group consisting of ketone solvents, aromatic solvents, organic chloride solvents, ether solvents, ether alcohol solvents, alcohol solvents and petroleum solvents, or a combination of at least two;
preferably, the solvents are in an amount which makes the solid content of polyphenolic P-N epoxy resin from 5% to 100%, more preferably from 20% to 100%;
preferably, the non-halogen epoxy resin is a bifunctional or multifunctional epoxy resin;
preferably, the bifunctional epoxy resin is one selected from the group consisting of liquid bisphenol A epoxy resin, liquid bisphenol F epoxy resin, solid bisphenol A epoxy resin, solid bisphenol F epoxy resin and bisphenol S epoxy resin and biphenyl-type epoxy resin, or a combination of at least two;
preferably, the multifunctional epoxy resin is one selected from the group consisting of phenolic epoxy resin, o-methyl phenolic epoxy resin, bisphenol A phenolic epoxy resin and cyclo-isoprene epoxy resin, or a combination of at least two.

7. A flame retardant compound, **characterized in** containing the polyphenolic P-N epoxy resin as claimed in claim 6;
preferably, further containing flame retardant epoxy resin, curing agents, auxiliaries, curing accelerators and halogen-free flame retardant fillers;
preferably, the flame retardant epoxy resin is one or at least two selected from the group consisting of DOPO epoxy resin, phosphorous-containing epoxy resin, nitrogen-containing epoxy resin, nitrogen-phosphorous-containing epoxy resin, phosphorous-containing phenolic epoxy resin, nitrogen-phosphorous-containing phenolic epoxy resin, silicon-containing epoxy resin and sulfur-containing epoxy resin;
preferably, the hardener is one selected from the group consisting of polyphenolic compound, amino compounds, benzoxazine resins, acid anhydride, polybasic acids, boron trifluoride and complexes thereof, or a combination of at least two;
preferably, the amino compounds are anyone selected from the group consisting of aliphatic amines or aromatic amines, such as dicyandiamide, diethyltriamine, diaminodiphenylmethane and diaminodiphenylsulfone, or a combination of at least two;
preferably, the polyphenolic compounds are one selected from the group consisting of bisphenol A, bisphenol F, bisphenol S, linear phenolic resin, o-methyl phenolic resin and bisphenol A phenolic resin, or a combination of at least two;
preferably, the equivalence ratio between the amount of the hardener and that of epoxy resin is from 0.4 to 1.5;
preferably, the curing accelerator is one or at least two selected from the group consisting of imidazoles, triphenylphosphine and derivatives theroeof, tertiary amines, quaternary amines, boron trifluoride and derivatives thereof;
preferably, the curing accelerator is in an amount of from 0.001% to 2.5%, more preferably from 0.03% to 1.2% of the total mass of epoxy resin;
preferably, the fillers are one or at least two selected from the group consisting of silicon dioxide, diatomite, kaoline, calcium carbonate, mica, titanium dioxide, magnesium hydroxide, and aluminium hydroxide;
preferably, the fillers are in an amount of less than 500 phr of the total mass of epoxy resin; and
preferably, the auxiliaries are one or more selected from the group consisting of defoaming agents, coupling agents, flexibilizers and flatting agents.

8. A prepreg, **characterized in that** it is produced by impregnating a substrate in the epoxy resin composition as claimed in claim 5 or the flame retardant composition as claimed in claim 7, or by coating the compositions on a substrate;
preferably, the substrate is glass fiber substrate, polyester substrate, polyimide substrate, ceramic substrate or carbon fiber substrate.

9. A composite metal laminate, **characterized in** comprising more than one prepreg as claimed in claim 8, and being produced by successively coating a metal layer on the surface of the prepreg, overlapping and pressing;
preferably, the metal layer is made of aluminium, copper, iron and alloys of any combinations thereof;
preferably, the composite metal laminate is, CEM-1 copper-clad laminate, CEM-3 copper-clad laminate, FR-4 copper-clad laminate, FR-5 copper-clad laminate, CEM-1 aluminum-clad laminate, CEM-3 aluminum-clad laminate, FR-4 aluminum-clad laminate or FR-5 aluminum-clad laminate.

10. A circuit board, **characterized in** being produced by processing circuit on the surface of the composite metal laminate as claimed in claim 9.
